Europäisches Patentamt

European Patent Office

Office européen des brevets

(11) Publication number: **0 426 000 A2**

# EUROPEAN PATENT APPLICATION

(21) Application number: 90120435.4

(51) Int. Cl.5: **H01L 39/24**

(22) Date of filing: 24.10.90

(30) Priority: 30.10.89 US 428702

(43) Date of publication of application:
08.05.91 Bulletin 91/19

(84) Designated Contracting States:
CH DE FR GB LI NL

(71) Applicant: Santa Barbara Research Center
75 Coromar Drive
Goleta California 93117(US)

(72) Inventor: Myrosznyk, James M.

1086 Via Los Padres
Santa-Barbara, California 93111(US)
Inventor: **Ray, Michael**
227 Hillview Drive
Goleta, California 93117(US)
Inventor: **Shott, Craig A.**
49 Dearborn Place, No. 7
Goleta, California 93117(US)

(74) Representative: **Kuhnen, Wacker & Partner**
**Schneggstrasse 3-5 Postfach 1553**
**W-8050 Freising(DE)**

(54) **Non-aqueous process for delineating patterns on high temperature superconductor films.**

(57) A method delineates a pattern upon a surface, such as a surface of HTS material, without exposing the surface to an aqueous based solution. The method includes the steps of forming a first layer over the surface, the first layer being comprised of a first photoresist selected to be impervious to water such as a type of poly-methacrylate resist. A second layer is formed over the first layer, the second layer being comprised of a second photoresist such as a conventional AZ-type positive photoresist. The first and the second layers are processed to remove portions of the first and the second layers to uncover a desired portion of the surface. Processing of the second photoresist layer with conventional aqueous-based solutions does not adversely affect the surface because of the intervening layer of water impervious photoresist. The surface is next processed by ion milling to delineate the surface or is processed by depositing a layer of metalization over at least the uncovered and previously delineated portion of the surface. Finally, there is performed a step of removing the first and second layers with a non-aqueous solvent, thereby also lifting off any metal deposited upon the second photoresist layer.

FIG.1a
FIG.1b
FIG.1c
FIG.1d
FIG.1e
FIG.1f
FIG.1g
FIG.1h
FIG.1i
FIG.1j
FIG.1k

# NON-AQUEOUS PROCESS FOR DELINEATING PATTERNS ON HIGH TEMPERATURE SUPERCONDUCTOR FILMS

## CROSS REFERENCE TO RELATED PATENT APPLICATION:

This Application is related to a commonly assigned U.S. Patent Application S.N. 07/317,716, filed March 2, 1989, entitled "High Temperature Superconductor Detector Fabrication Process", by J. Myroszynk et al.

## FIELD OF THE INVENTION:

This invention is related generally to fabrication methodologies for films and, in particular, to the delineation of a pattern upon a surface of film and to the deposition of metal upon a film surface with a liftoff process that prevents the exposure of the film surface to water.

## BACKGROUND OF THE INVENTION:

It is known that some films, such as films comprised of High Temperature Superconductor (HTS) material, are adversely affected when exposed to water. In that aqueous-based processing techniques are widely used and well-characterized a significant problem is encountered when attempting to employ aqueous based processing techniques with HTS and other material. These problems are especially apparent when it is desired to delineate the surface of the HTS film and when it is desired to deposit metalization upon the surface of the HTS material.

In particular, as the technology for HTS device fabrication matures silver has evolved as a metal of choice for contacting HTS material due to its relatively low contact resistance of approximately $10^{-6}$ OHM. However, the development of dry plasma-type etching techniques for various metalizations, such as silver, generally requires significant labor and expense to perfect. Until the development of the inventive process taught herein no truly cost-effective processing techniques were available for delineating silver contact metalization on HTS material.

It is therefore an object of the invention to provide for the deposition of a wide variety of metals upon a film surface without incurring the costs associated with development of a plasma or reactive ion dry etch.

It is a further object of the invention to provide for the application of silver contacts on HTS films to exploit the exceptionally low contact resistance of silver to HTS films.

It is another object of the invention to provide a liftoff process that allows the use of conventional and well-characterized photoresists without exposing a HTS film to an aqueous based developing solution.

## SUMMARY OF THE INVENTION

The foregoing problems are overcome and the objects of the invention are realized by a novel photoresist liftoff process that allows a variety of metals to be used to electrically contact HTS and other films. The process also provides a non-aqueous technique for delineating a surface of HTS and other types of films.

A method of the invention delineates a pattern upon a surface without exposing the surface to an aqueous based solution. The method includes the steps of forming a first layer over the surface, the first layer being comprised of a first photoresist selected to be impervious to water. In accordance with the invention the first layer is preferably comprised of a type of polyfluoromethacrylate E-beam resist such as polyflourobutyl methacrylate (FBM). A second layer is formed over the first layer, the second layer being comprised of a second photoresist such as a conventional AZ-type positive photoresist. The first and the second layers are processed to remove portions of the first and the second layers to uncover a desired portion of the surface. The layers are processed by the steps of (a) exposing the second layer, (b) wet developing the exposed second layer with an aqueous based solution to remove a portion of the second layer to uncover an underlying portion of the first layer, and (c) removing with a non-aqueous technique the uncovered portion of the first layer to uncover an underlying portion of the surface, the step of removing with a non-aqueous technique may include a step of undercutting the first layer beneath the second layer. Processing of the second photoresist layer with conventional aqueous-based solutions does not adversely affect the surface because of the intervening first layer of water impervious photoresist. Next there is deposited a layer of metalization over the uncovered and previously delineated portion of the surface. Alternatively, the uncovered portion of the surface is delineated into predetermined regions using the first and second layers as a processing mask. Finally, there is performed a step of removing the first and second layers with a non-aqueous solvent, thereby also lifting off any metal deposited upon the second photoresist layer.

## BRIEF DESCRIPTION OF THE DRAWING

The above set forth and other features of the invention are made more apparent in the ensuing Detailed Description of the Invention when read in conjunction with the attached Drawing, wherein:

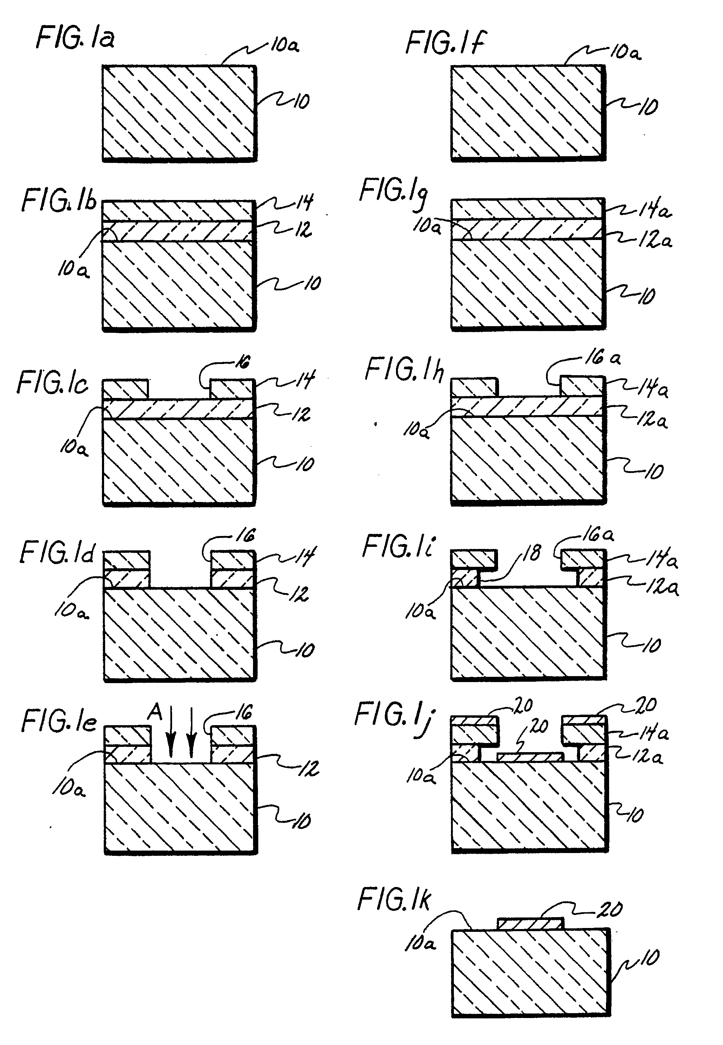

Figs. 1a-1k illustrate various steps of a method of the invention.

## DETAILED DESCRIPTION OF A PREFERRED EMBODIMENT OF THE INVENTION

Although the method of the invention is described below in the context of silver metalization formed upon a surface of layer comprised of HTS material it should be realized that the teaching of the invention applies to the deposition of a number of different types of metals on a variety of different types of water degradable materials, such as organic polymer films. Therefore, the method of the invention should not to be construed to be limited for use only with silver metalization and HTS material.

Referring first to Fig. 1a an initial step of the method provides a body of material such as a substrate 10 having a layer or film 10a of HTS material on a surface thereof. The substrate 10 may be any type of substrate material known to be suitable for use with HTS material. By example, the substrate 10 may be comprised of MgO, $SrTiO_3$ or $ZrO_2$. The HTS film 10a may be comprised of, by example, $Y_1Ba_2Cu_3O_{7-x}$ or $Tl_2Ca_2Ba_2Cu_3O_{10}$.

In Fig. 1b there is applied over the HTS film 10a, in a conventional manner, a protective photoresist layer 12 of a type that is substantially insoluble in and impervious to water. In accordance with the invention the layer 12 is preferably comprised of a type of polyfluoromethacrylate electron-beam (E-beam) photoresist such as polyflourobutyl methacrylate (FBM). The layer 12 is applied to a typical thickness of approximately 0.5 microns. The FBM resist layer 12 is cured in a known manner. Next a conventional aqueous-based photoresist is applied. This photoresist is by example an AZ-type positive photoresist layer 14 that is applied by conventional technique over the top of the cured FBM resist layer 12. The AZ photoresist layer 14 is typically applied to thickness of approximately three microns and is cured in a known manner. Typically, both the layers 12 and 14 are applied by being spun-on.

In Fig. 1c the AZ resist layer 14 is UV exposed to create an ion mill etch mask for delineating features on the HTS film 10a. The layer 14 is subsequently wet developed per conventional aqueous-based methods. As a result the patterned AZ resist layer 14 has portions removed creating walls 16 and uncovering the underlying FBM resist layer 12. In accordance with the invention the water impervious FBM resist layer 12 protects the underlying HTS film 10a from exposure to the AZ photoresist aqueous developer.

In Fig. 1d the uncovered portion of the FBM resist layer 12 is dry developed out with a non-aqueous technique such as with a UV-Ozone asher. Typically the FBM resist layer 12 is developed out for a sufficient amount of time to create retrograde profile or undercut regions 18, as seen in Fig. 1i, within the FBM resist layer 12. It should be noted that the formation of the retrograde profile is not required at this step of the method in preparation for the ensuing surface delineation step. As will be discussed below the retrograde profile is advantageous for a subsequent metalization liftoff step.

It is noted that other water-insoluble polymers such as polyimide or PMMA could be used for the layer 12. Also, a plasma oxygen technique could be employed for removing the polymers. However it is noted that UV/Ozone development is generally considered to be a more benign process and minimizes damage to the HTS surface. Although polyimide or PMMA can be developed out with the UV/Ozone technique the time required to do so may be prohibitive. In that polyfluoromethylacrylates are known to break down rapidly by the UV/Ozone technique their use with UV/Ozone ashing constitutes a presently preferred processing methodology.

In Fig. 1e an ion mill is employed to mill, as indicated by the arrows A, the HTS film 10a to delineate features within the HTS film 10a. These features may include radiation detectors, switching devices and/or other desired active or passive structures. The relatively thick AZ photoresist layer 14 advantageously protects the HTS film 10a during this step of ion milling.

Subsequently at Fig. 1f remaining portions of both resist layers 12 and 14 are removed with a non-aqueous solvent such as acetone. The resulting structure is the substrate 10 having a delineated HTS film 10a. This structure is now ready for subsequent metalization in order to conductively couple the individual devices one to another and to input/output pads.

In Fig. 1g the FBM and AZ photoresist is once more applied, as previously described, to form the layers 12a and 14a. In Fig. 1h the AZ layer 14a is patterned using a dark field contact metal pattern and portions are removed by an aqueous-based technique to create openings having sidewalls 16a. In Fig, 1i the underlying FBM layer 12a is dry developed out for a period of time sufficient to ensure the formation of the retrograde profile as evidenced by the undercut regions 18.

In Fig. 1j a desired contact metal, such as silver, is deposited, preferably by sputtering, to form a metallic layer 20 over the surface of the delineated HTS film 10a and over the surface of the AZ photoresist layer 14a. Preferably the step of sputtering includes an initial pre-sputter etch step to remove residual organic contamination from the surface of the HTS film 10a.

In Fig. 1k a liftoff step is accomplished by applying a non-aqueous solvent such as acetone that removes remaining portions of the FBM resist layer 12a and the overlying AZ resist layer 14a, thereby also rejecting extraneous metal. As a result, there is produced on the HTS film 10a a region of contact metalization in the form of the metal layer 20.

It can be seen that the method of the invention provides for delineating films such as HTS films or the deposition of metal films on HTS material by the use of conventional photoresists and without exposing the film to aqueous based solutions. Furthermore, due to the undercutting of the resist layers the deposited metal does not adhere to the adjacent resist sidewalls. Thus the delineation of fine lines and tight geometries is made possible with a liftoff technique without also introducing extraneous and undesirable "flaps" of material at the edge of the pattern.

In particular, the method of the invention permits the use of a desired contact metalization, such as silver, without requiring the corresponding development of a costly and time consuming dry plasma-type etching technique for applying the desired metalization.

While the invention has been particularly shown and described with respect to a presently preferred embodiment thereof, it will be understood by those skilled in the art that changes in form and details may be made therein without departing from the scope and spirit of the invention. As such, the scope of the invention is intended to be limited only as the invention is defined by the Claims that follow.

## Claims

1. A method of processing a surface of a water-degradable material without exposing the surface to an aqueous solution, comprising the steps of:
providing the surface of a water-degradable material;

forming a first layer over the surface, the first layer being comprised of a first photoresist material selected to be substantially impervious to water;
forming a second layer over the first layer, the second layer being comprised of a second photoresist material that is processed by aqueous-based technique;
processing the first and the second layers to remove portions of the first and the second layers to uncover a desired portion of the surface;
processing the uncovered portion of the surface; and
removing the first and second layers.

2. A method as set forth in Claim 1 wherein the step of forming the first layer includes a step of forming a layer comprised of a type of polyfluoromethacrylate photoresist.

3. A method as set forth in Claim 1 wherein the step of forming the first layer includes a step of forming a layer comprised of polyflourobutyl methacrylate (FBM).

4. A method as set forth in Claim 1 wherein the step of forming the second layer includes a step of forming a layer comprised of AZ-type positive photoresist.

5. A method as set forth in Claim 1 wherein the step of processing includes the steps of:
exposing the second layer; and
wet developing the exposed second layer with an aqueous-based technique to remove a portion of the second layer to uncover an underlying portion of the first layer.

6. A method as set forth in Claim 5 wherein the step of exposing includes a step of U.V. exposure to create a pattern upon the second layer.

7. A method as set forth in Claim 5 wherein the step of processing further includes a step of removing with a non-aqueous technique the uncovered portion of the first photoresist layer.

8. A method as set forth in Claim 7 wherein the step of removing with a non-aqueous technique includes a step of dry developing with a UV-Ozone asher.

9. A method as set forth in Claim 7 wherein the step of removing with a non-aqueous technique includes a step of undercutting the first layer beneath the second layer.

10. A method as set forth in Claim 1 wherein the step of processing the surface includes a step of depositing a metallic layer upon the surface.

11. A method as set forth in Claim 10 wherein the step of depositing includes a step of sputter depositing, the step of sputter depositing further including an initial step of pre-sputter etching to remove organic contamination from the surface.

12. A method as set forth in Claim 1 wherein the step of processing the surface includes a step of ion milling the surface to delineate one or more structures thereon.

13. A method as set forth in Claim 1 wherein the step of removing includes a step of applying a non-aqueous solvent.

14. A method as set forth in Claim 1 wherein the step of forming the first layer includes a step of forming a layer comprised of polyflourobutyl methacrylate (FBM) to a depth of approximately 0.5 microns.

15. A method of forming contact metalization upon a surface of a HTS material without exposing the surface to an aqueous solution, comprising the steps of:

providing the surface:

forming a water-impervious first layer over the surface, the first layer being comprised of a type of polyfluoromethacrylate photoresist;

forming a second layer over the first layer, the second layer being comprised of AZ-type positive photoresist;

processing the first and the second layers to remove portions of the first and the second layers to uncover a desired portion of the surface, the step of processing including the steps of,

U.V. exposing selected portions of the second layer;

wet developing the second layer with an aqueous based solution to remove a portion of the second layer to uncover an underlying portion of the first layer; and

removing with a non-aqueous technique the uncovered portion of the first layer to uncover an underlying portion of the surface;

delineating the uncovered portion of the surface into a desired pattern;

removing the first and second layers with a non-aqueous solvent;

with a dark field metalization pattern,

forming another water-impervious first layer over the surface, the first layer being comprised of a type of polyfluoromethacrylate photoresist;

forming another second layer over the first layer, the second layer being comprised of AZ-type positive photoresist;

processing the first and the second layers to remove portions of the first and the second layers to uncover a desired portion of the surface, the step of processing including the steps of,

U.V. exposing selected portions of the second layer;

wet developing the second layer with an aqueous based solution to remove a portion of the second layer to uncover an underlying portion of the first layer; and

removing with a non-aqueous technique the uncovered portion of the first layer to uncover an underlying portion of the surface, the step of removing with a non-aqueous technique including a step of undercutting the first layer beneath the second layer;

sputtering a layer of metalization over at least the uncovered portion of the surface; and

removing the first and second layers with a non-aqueous solvent.

16. A method as set forth in Claim 15 wherein the step of forming the first layer forms a layer comprised of polyflourobutyl methacrylate (FBM).

17. A method as set forth in Claim 7 wherein the step of removing with a non-aqueous technique includes a step of dry developing with an oxygen plasma.

18. A method as set forth in Claim 15 wherein the step of delineating includes a step of ion milling the surface.

19. A method as set forth in Claim 10 wherein the step of depositing deposits a layer comprised of silver.

20. A method as set forth in Claim 15 wherein the step of sputtering sputters a layer comprised of silver.

FIG.1a

10a
10

FIG.1f

10a
10

FIG.1b

14
12
10a
10

FIG.1g

14a
10a
12a
10

FIG.1c

16
14
12
10a
10

FIG.1h

16a
14a
12a
10a
10

FIG.1d

16
14
12
10a
10

FIG.1i

16a
18
14a
12a
10a
10

FIG.1e

A
16
12
10a
10

FIG.1j

20
20
20
14a
12a
10a
10

FIG.1k

20
10a
10